# EUROPÄISCHE PATENTSCHRIFT

(11) **EP 1 061 380 B1**
(45) Veröffentlichungstag und Bekanntmachung des Hinweises auf die Patenterteilung: **07.06.2006**
(21) Anmeldenummer: 00202105.3
(22) Anmeldetag: 15.06.2000
(51) Int. Cl.: G01R 33/483, G01R 33/54

(54) **MR-Verfahren zur Unterdrückung von MR-Signalen aus ausserhalb eines Isozentrums befindlichen Randbereichen**
Method for the suppression of MR signals from regions outside an isocentre
Procédé RM de suppression des signaux de résonance magnétique des zones périphériques à l'extérieur d'un isocentre

(30) Priorität: 19.06.1999 DE 19928110
(43) Veröffentlichungstag der Anmeldung: 20.12.2000
(73) Patentinhaber: Philips Intellectual Property & Standards GmbH, 20099 Hamburg (DE); Koninklijke Philips Electronics N.V., 5621 BA Eindhoven (NL)
(72) Erfinder: Aldefeld, Bernd, Philips Int. Prop. & Stand. GmbH, 20099 Hamburg (DE); Overweg, Johannes, Philips Int.Prop.&Stand. GmbH, 52064 Aachen (DE)
(74) Vertreter: Volmer, Georg

(56) Entgegenhaltungen:
- WO-A-98/47014
- DE-A- 3 803 052
- DE-A- 4 224 237
- US-A- 4 804 919
- US-A- 5 451 875
- US-A- 5 467 016

## Beschreibung

Die Erfindung betrifft ein MR-Verfahren zur Unterdrückung von MR-Signalen aus außerhalb eines Isozentrums befindlichen Randbereichen.

Außerdem betrifft die Erfindung ein MR-Gerät zur Durchführung des Verfahrens.

In MR-Bildern, die ein bestimmtes Gesichtsfeld (Field of View, abgekürzt FOV) abbilden sollen, können Artefakte auftreten, die von unerwünschten MR-Signalen herrühren, die in Randbereichen auftreten, in denen die Bedingungen für eine Magnetresonanz ebenso erfüllt sind wie im FOV. Dazu kann es insbesondere bei MR-Geräten mit vergleichsweise kurzen Gradientenspulen kommen, bei denen schon in geringem Abstand vom Isozentrum der Gradient des von diesen Spulen erzeugten Magnetfeldes abnimmt und sein Vorzeichen umkehrt. In den Randbereichen, in denen diese Umkehr stattfindet, kann das sogenannte B₀-Feld noch immer so stark sein, dass auch dort die Resonanzbedingungen erfüllt sind und unerwünschte MR-Signale entstehen, wenn diese Randbereiche vom Hochfrequenz-Magnetfeld erfaßt werden. Es ist dabei nicht möglich, die Kernmagnetisierung in den Randbereichen gemäß der DE-A 36 04 281 (PHD 86-018) zu sättigen, weil bei dem angegebenen räumlichen Verlauf des Gradienten das Magnetfeld in den Randbereichen die gleiche Größe haben kann, wie im Bereich um das Isozentrum.

Zur Verhinderung von unerwünschten Signalen aus den Randbereichen der Gradientenspule ist es aus der US-A-5 451 875 bekannt, die Kemmagnetisierung in einem Randbereich zu sättigen. Zu diesem Zweck wird ein Hochfrequenzimpuls und mit einer weiteren Gradientenspule kurzzeitig ein Magnetfeld erzeugt, wodurch die Kernmagnetisierung in mindestens einem Randbereich angeregt wird. Anschließend wird die angeregte Kernmagnetisierung dephasiert, so dass bei einer anschließenden bildgebenden Sequenz in diesem Randbereich keine MR-Signale entstehen können.

Ein Verfahren zur Sättigung von Bereichen, die angrenzend zu einem zu untersuchenden Bereich liegen und diesen einschliessen, ist aus der DE-A-38 090 052 bekannt. Dazu wird die kernmagnetisierung in den Randbereichen nacheinander und mit entgegengesetzer Polarität des gradientenfeldes angeregt.

Aufgabe der vorliegenden Erfindung ist es daher, ein Verfahren anzugeben, bei dem MR-Signale aus Randbereichen wirksam, mit geringem Aufwand und geringer Verlängerung der Meßzeit unterdrückt werden können. Diese Aufgabe wird erfindungsgemäß gelöst durch folgende Schritte:
a) Erzeugen eines ortsabhängigen, kurzzeitig stationären Magnetfeldes, dessen Feldstärke in den Randbereichen entweder größer oder kleiner als seine Feldstärke im Isozentrum ist, wobei sich die Randbereiche auf gegenüberliegenden Seiten des Isozentrums befinden
b) Erzeugung wenigstens eines Hochfrequenzimpulses während der Einwirkung des Magnetfeldes, der die Kernmagnetisierung in den Randbereichen, aber nicht im Isozentrum anregt,
c) Dephasierung der angeregten Kernmagnetisierung.

Die Erfindung beruht auf der Überlegung, dass, wenn man ein ortsabhängiges, kurzzeitig stationäres Magnetfeld erzeugen kann, dessen Feldstärke in den Randbereichen entweder größer oder kleiner ist als im Isozentrum, man stets einen Hochfrequenzimpuls erzeugen kann, der die Kernmagnetisierung nur in den Randbereichen anregt, aber nicht im Isozentrum. Danach können die angeregten Kernspins in den Randbereichen dephasiert werden, so dass dort durch diese "Sättigung" (einstweilen) kein MR-Signal mehr auftreten kann.

Als "kurzzeitig stationär" wird hierbei und im folgenden ein Magnetfeld bezeichnet, das während eines Zeitraums von mindestens einigen Perioden der im Hochfrequenzimpuls enthaltenen Hochfrequenzschwingung seine Polarität nicht ändert. Der Begriff "kurzzeitig" wird im folgenden auch weggelassen, wenn Verwechslungen mit dem stationären (B₀-) Hauptmagnetfeld nicht zu befürchten sind. Typischerweise ist das kurzzeitig stationäre Magnetfeld während eines Zeitraums in der Größenordnung von 1 ms konstant.

Die Ausgestaltung nach Anspruch 2 bewirkt, dass die sich an die Sättigung anschließende MR-Untersuchung durch das ortsabhängige kurzzeitig stationäre Magnetfeld nicht beeinflusst wird.

Ein MR-Gerät zur Durchführung des Verfahrens nach Anspruch 1 mit einem Hauptfeldmagneten zur Erzeugung eines homogenen, stationären Magnetfeldes ist in Anspruch 3 beschrieben. Das ortsabhängige, stationäre Magnetfeld wird dabei mit einer (zusätzlichen) Sättigungsspulen-Anordnung erzeugt, die so beschaffen ist, dass in den Randbereichen beiderseits des Zentrums dieser Spule das Magnetfeld entweder stärker oder schwächer ist als im Isozentrum. Eine solche Sättigungsspulen-Anordnung kann die gleiche Länge haben, oder sogar noch kürzer sein, als die Gradientenspule, deren Feldverlauf zu den unerwünschten MR-Signalen führen kann. Eine bevorzugte Ausgestaltung eines solchen MR-Gerätes ist in Anspruch 4 beschrieben. Wenn die beiden seitlichen Spulenabschnitte die gleiche Windungszahl und von dem mittleren Spulenabschnitt den gleichen Abstand haben, ergibt sich ein symmetrischer Feldverlauf. Es ist jedoch auch möglich, durch Änderung des Abstandes oder der Windungszahl, einen unsymmetrischen Verlauf zu erzielen.

Bei der Ausgestaltung nach Anspruch 5 ist die Gradientenspulen-Anordnung gleichsam mit der Sättigungsspulen-Anordnung räumlich verschachtelt, so dass kein zusätzlicher Einbauraum erforderlich wird.

Die Erfindung wird nachstehend anhand der Zeichnungen näher erläutert. Es zeigen:
Fig. 1 Ein schematisch dargestelltes Blockschaltbild eines erfindungsgemäßen MR-Gerätes.
Fig. 2 Die räumliche Anordnung eines Teils eines solchen Gerätes.
Fig. 3 Den resultierenden Verlauf der Magnetfelder und
Fig. 4 ein Beispiel einer damit durchführbaren Sequenz.

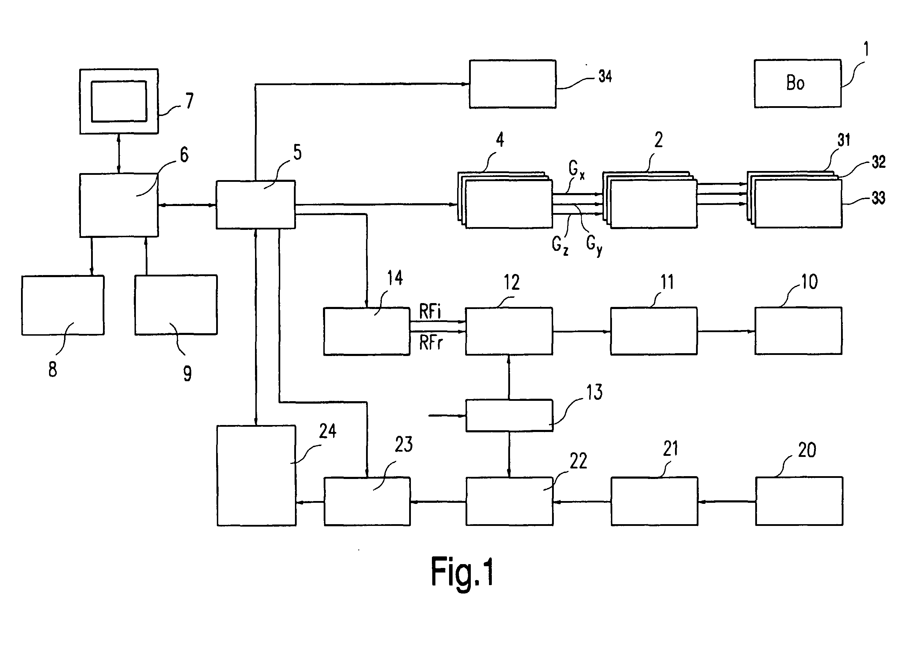

In Fig. 1 ist mit 1 ein schematisch dargestellter Hauptfeldmagnet bezeichnet, der in einem nicht näher dargestellten Untersuchungsbereich ein beispielsweise in z-Richtung verlaufendes, stationäres und im wesentlichen homogenes Magnetfeld B₀ mit einer Stärke von z.B. 1,5 Tesla erzeugt. Die z-Richtung verläuft dabei in Längsrichtung eines nicht näher dargestellten Patientenlagerungstisches auf dem sich während einer Untersuchung ein Patient befindet.

Weiterhin sind Gradientenspulen-Anordnungen 31,32 und 33 vorgesehen, mit denen in z-Richtung verlaufende, magnetische Gradientenfelder Gₓ, G_{y}, bzw. G_{z} mit einem in x-,y-bzw. z-Richtung verlaufenden Gradienten erzeugt werden können. Die Ströme für die Spulensysteme 31,32 und 33 werden von je einem Gradientenverstärker 2 geliefert. Ihr zeitlicher Verlauf wird von einem Wave-Form-Generator 4 vorgegeben und zwar für jede Richtung gesondert. Der Wave-Form-Generator 4 wird von einer Rechen- und Steuereinheit 5 gesteuert, die den für ein bestimmtes Untersuchungsverfahren erforderlichen zeitlichen Verlauf der magnetischen Gradientenfelder Gₓ, G_{y}, G_{z} berechnet und in den Wave-Form-Generator 4 lädt. Bei der Untersuchung werden diese Signale aus dem Wave-Form-Generator ausgelesen und der Gradientenverstärkeranordnung 2 zugeführt, die daraus die für die Spulensysteme 31,32 und 33 erforderlichen Ströme erzeugt.

Die Steuereinheit 5 wirkt außerdem noch mit einer Work-Station 6 zusammen, die mit einem Monitor 7 zur Wiedergabe von MR-Bildern vorgesehen ist. Über eine Tastatur 8 oder einer interaktive Eingabeeinheit 9 sind Eingaben möglich.

Die Kernmagnetisierung im Untersuchungsbereich kann durch Hochfrequenzimpulse einer Hochfrequenzspule 10 angeregt werden, die an einen Hochfrequenzverstärker 11 angeschlossen ist, der die Ausgangssignale eines Hochfrequenzsenders 12 verstärkt. In dem Hochfrequenzsender 12 werden die (komplexen) Einhüllenden der Hochfrequenzimpulse mit den von einem Oszillator 13 gelieferten Trägerschwingungen moduliert, deren Frequenz der Larmorfrequenz (bei einem Hauptmagnetfeld von 1,5 Tesla ca. 63 MHz) entspricht. Die komplexe Einhüllende wird von der Rechen- und Steuereinheit in einem Generator 14 geladen, der mit dem Sender 12 gekoppelt ist.

Die im Untersuchungsbereich erzeugten MR-Signale werden von einer Empfangsspule 20 aufgenommen und von einem Verstärker 21 verstärkt. Anstelle einer Hochfrequenzspule 10 für die Erzeugung von Hochfrequenzimpulsen und einer Empfangsspule 20 für den Empfang von MR-Signalen, kann auch eine einzige Spule vorgesehen sein, die die Hochfrequenzimpulse erzeugt und anschließend die MR-Signale empfängt.

Das im Verstärker 21 verstärkte MR-Signal wird in einem Quadratur-Demodulator 22 durch zwei um 90° gegeneinander versetzte Trägerschwingungen des Oszillators 13 demoduliert, so dass zwei Signale erzeugt werden, die als Realteil und als Imaginärteil eines komplexen MR-Signals aufgefasst werden können. Diese Signale werden einem Analog-Digital-Wandler 23 zugeführt, der daraus MR-Daten ableitet. Aus den von einem MR-Signal abgeleiteten MR-Daten wird in einer Bildverarbeitungseinheit 24 ein MR-Bild erzeugt. Dieses kann auf dem Monitor 7 wiedergegeben werden.

Zusätzlich ist eine Spulenanordnung 34 zur Sättigung der Kernmagnetisierung in den Randbereichen vorgesehen. Diese Spule wird im folgenden als Sättigungsspule bezeichnet. Die Stärke und das Ein- und Ausschalten des kurzzeitig stationären Gleichstroms durch die Sättigungsspule 34 wird ebenfalls von der Rechen- und Steuereinheit 5 gesteuert. Typischerweise hat der Strom in der Sättigungsspule einen trapezoidförmigen zeitlichen Verlauf, der einige ms dauert.

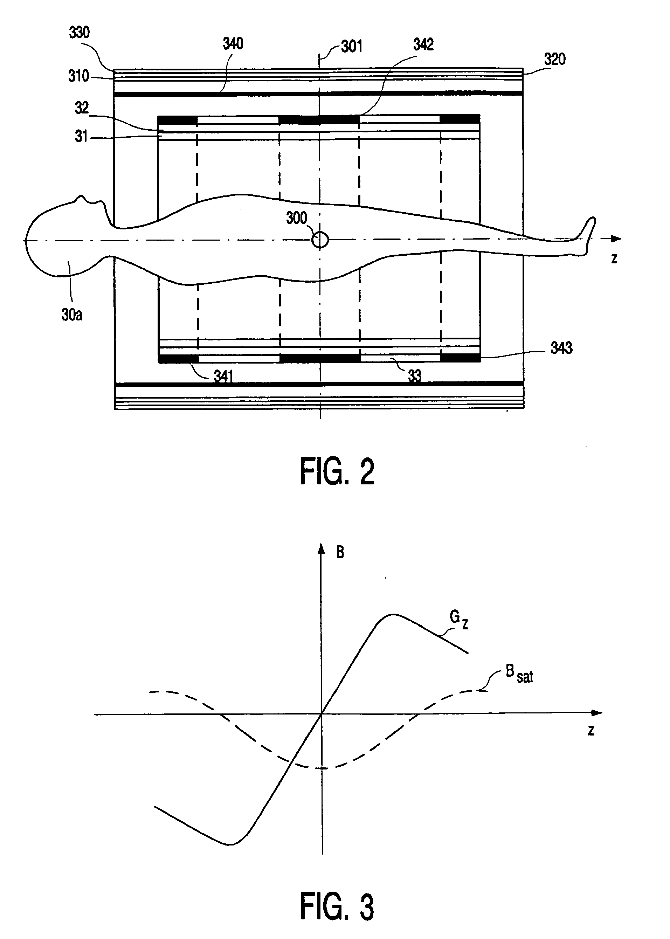

Fig. 2 stellt u.a. die Gradientenspulen 31,32 und 33 sowie die Sättigungsspule schematisch dar. Die Spulen sind koaxial zueinander angeordnet, wobei die Spulenachse mit der z-Richtung, d.h. mit der Längsrichtung des Patienten bzw. mit der Längsrichtung der nicht näher dargestellten Patientenlagerungsplatte zusammenfällt, so dass der Patient von diesen Spulen umschlossen wird. Alle Spulen erzeugen in z-Richtung verlaufende stationäre Magnetfelder, wobei das Magnetfeld der innersten Gradientenspule 31 einen in x-Richtung (vertikal) verlaufenden Gradienten hat, während die sie umschließende Gradientenspule 32 einen in y-Richtung (senkrecht zur Zeichenebene) verlaufenden Gradienten und die äußere Gradientenspule 33 einen in z-Richtung (horizontal) verlaufenden Gradienten aufweist. Im Isozentrum 300 sind die von den drei Spulen erzeugten Magnetfelder Null, und außerhalb dieses Isozentrums ändern sie sich gegensinnig.

Das Isozentrum 300 fällt mit der Spulenachse bzw. mit dem Mittelpunkt der Spulen 31,32 und 33 zusammen. Üblicherweise liegt das Isozentrum auch im Zentrum des Hauptfeldmagneten und im Zentrum der Hochfrequenzspule, die in Fig. 2 nicht näher dargestellt wird. Die Gradientenspule 33 kann eine Spulenanordnung vom Helmholztyp sein, die aus zwei gleichen Spulenabschnitten besteht, die symmetrisch zu einer senkrecht zur z-Achse durch das Isozentrum verlaufenden Mittelebene 301 angeordnet sind und gegensinnig von einem gemeinsamen Strom durchflossen werden.

Die Sättigungsspule 34 besteht aus drei elektrisch in Serie geschalteten Spulenabschnitten 341, 342 und 343, die in z-Richtung gegeneinander versetzt und symmetrisch zur Ebene 301 angeordnet sind. Die beiden äußeren Spulenabschnitte 341 und 343 haben die gleiche Windungszahl, während der in der Mitte befindliche Spulenabschnitt 342 etwa die doppelte Windungszahl und den entgegengesetzten Windungssinn hat wie die beiden äußeren Abschnitte 341 und 343. Wenn diese drei Spulenabschnitte von einem gemeinsamen Strom durchflossen werden, weist dieser im mittleren Spulenabschnitt also einen entgegengesetzten Umlaufsinn auf wie in den beiden äußeren Spulenabschnitten.

Der mittlere Spulenabschnitt 342 wird von den beiden Abschnitten der Gradientenspule 33 umschlossen, während die beiden äußeren Spulenabschnitte 341 und 342 ihrerseits diese beiden Abschnitte der Spule 33 umschließen. Das durch die beiden ineinander verschachtelten 33 und 34 entstehende Spulengebilde ist nicht länger als die beiden anderen Gradientenspulen 31 und 32, so dass durch die zusätzliche Sättigungsspule 34 kein zusätzlicher Bauraum beansprucht wird.

Die Spulen 31 bis 34 werden durch vier konzentrisch zueinander angeordnete Spulen 310, 320, 330 und 340 umschlossen, die eine ähnliche Charakteristik haben, wie die Spulen 31 bis 34 und die zeitgleich mit diesen von einem Strom durchflossen werden - allerdings jeweils mit entgegengesetztem Umlaufsinn. Dadurch kompensiert beispielsweise das Magnetfeld der Spule 310 im Außenraum, d.h. jenseits der Spulen 310-340, das Magnetfeld der Spule 31. Diese Kompensation ist als "aktive Schirmung" an sich bekannt.

Fig. 3 zeigt den räumlichen Verlauf des von der Spule 33 erzeugten Magnetfeldes G_{z} in z-Richtung. Die magnetische Feldstärke verläuft antisymmetrisch zur Mittelebene 301, d.h. sie nimmt auf der einen Seite linear zu und auf der anderen Seite linear ab. Etwa in der Mitte der Spulenabschnitte 33 erreicht die Feldstärke ihr Maximum, um dann für größere positive oder negative Werte von z wieder abzunehmen. Der Gradient dieses Magnetfeldes in z-Richtung ist also im Bereich um das Isozentrum konstant und nimmt nach außen hin ab, wobei er sein Vorzeichen umkehrt. In den Randbereichen jenseits dieses Umkehrpunktes kann die aus diesem Gradientenfeld (und dem Feld B₀ des Hauptfeldmagneten) gleich große Werte annehmen, was zur Folge hat, dass die Resonanzbedingung sowohl in dem Randbereich als auch in einem Bereich um das Isozentrum erfüllt ist, so dass die entstehenden MR-Signale nicht mehr eindeutig einem dieser Bereiche zugeordnet werden können.

In Fig. 3 ist zusätzlich der räumliche Verlauf des von der Sättigungsspule 34 erzeugten Magnetfeldes Bₛₐₜ gezeichnet. Von einem negativen Wert in der Mittelebene ausgehend nimmt dieses Feld nach beiden Seiten hin zu, wobei in den erwähnten Randbereichen die Feldstärke ihr Vorzeichen umkehrt. Bei einem symmetrischen Aufbau der Sättigungsspule 34 ergibt sich ein symmetrischer Verlauf von Bₛₐₜ und anderenfalls ein unsymmetrischer Verlauf, jedoch auch dann noch so, dass das magnetische Feld von der Mittelebene (z=0) ausgehend sich in Richtung positiver und negativer z-Werte in gleichem Sinne ändert.

Wenn die Richtung des Stromes durch die Sättigungsspule 34 umgekehrt wird, ist die Feldstärke in der Mittelebene 301 positiv und in den Randbereichen negativ. Durch Änderung des Aufbaus der Spule kann die Feldstärke in der Mittelebene und/oder in den Randbereichen geändert werden. Wesentlich ist dabei lediglich, dass sich die Feldstärke des von der Spule 34 hervorgerufenen Magnetfeldes von der Mittelebene 301 ausgehend zu beiden Seiten hin in gleichem Sinne ändert und dass der Feldstärkeunterschied zwischen den Randbereichen einerseits und dem Isozentrum andererseits genügend groß ist.

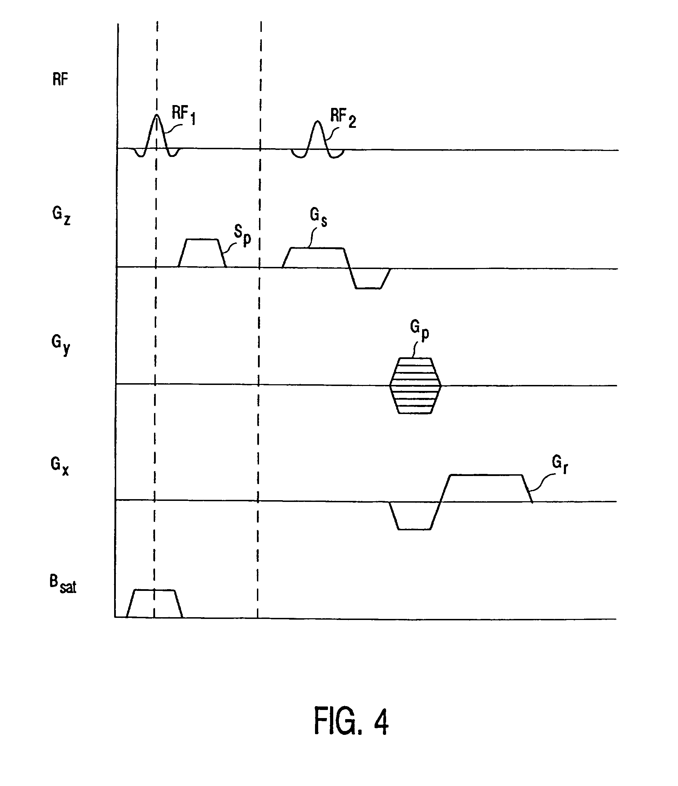

Fig. 4 zeigt den zeitlichen Verlauf verschiedener Signale bei einer MR-Sequenz nach dem 2DFT-Verfahren, wobei die unerwünschten Signale aus den Randbereichen mit Hilfe des Feldes Bₛₐₜ unterdrückt werden. Das Verfahren umfasst zwei zeitlich aufeinander folgende Abschnitte. Im ersten Abschnitt wird die Kernmagnetisierung in den Randbereichen gesättigt und im zweiten Abschnitt wird eine übliche Sequenz appliziert - im Beispiel nach dem 2DFT-Verfahren.

Im ersten Abschnitt wird ein Hochfrequenzimpuls RF₁ (erste Zeile) erzeugt und gleichzeitig das Magnetfeld Bₛₐₜ (5. Zeile) der Sättigungsspule 34 eingeschaltet. Durch geeignete Wahl der Mittenfrequenz dieses Hochfrequenzimpulses und seiner Bandbreite und ggf. der Stärke des Stroms durch die Sättigungsspule) wird erreicht, dass dieser Impuls lediglich die Kernmagnetisierung in zwei Bereichen außerhalb des Isozentrums - aber nicht in dem Bereich um das Isozentrum - anregt. Die angeregte Kernmagnetisierung wird anschließend durch einen sogenannten "Spoiler" Sp dephasiert. Unter einem Spoiler versteht man das Ein- und Ausschalten eines Gradientenfeldes (z.B. mit in z-Richtung verlaufenden Gradienten - 2. Zeile). Das gleiche lässt sich aber auch dadurch erreichen, dass man die Einschaltdauer des von der Spule 34 erzeugten Magnetfeldes Bₛₐₜ genügend lang macht.

Danach ist also die Kernmagnetisierung in den Randbereichen dephasiert, während sie im Bereich um das Isozentrum unverändert ist. Die anschließende Bildgebungssequenz kann sich dann nur noch auf den Bereich um das Isozentrum auswirken. Dabei wird zunächst ein Hochfrequenzimpuls RF₂ in Verbindung mit einem Schichtselektionsgradienten G, z.B. in z-Richtung (2. Zeile) eingeschaltet.

Nach diesem schichtselektiven Hochfrequenzimpuls wird ein Phasenkodierungs-Gradient Gₚ, z.B. in y-Richtung (3. Zeile) eingeschaltet und das dadurch hervorgerufene MR-Signal wird unter der Wirkung eines Lese-Gradienten Gᵣ ausgelesen. Solange die Kernmagnetisierung in den Randbereichen dephasiert ist, können sich weitere Anregungen der Schicht mit geändertem Phasenkodierungs-Gradienten Gₚ anschließen, ohne dass unerwünschte MR-Signale in den Randbereichen entstehen können.

## Patentansprüche

1. MR-Verfahren zur Unterdrückung von MR-Signalen aus außerhalb eines Isozentrums befindlichen Randbereichen,
**gekennzeichnet durch** folgende Schritte:
a) Erzeugen eines ortsabhängigen, kurzzeitig stationären Magnetfeldes (Bₛₐₜ), dessen Feldstärke in den Randbereichen entweder größer oder kleiner als seine Feldstärke im Isozentrum ist, wobei sich die Randbereiche auf gegenübediegenden Seiten der Isozentrums befinden
b) Erzeugung wenigstens eines Hochfrequenzimpulses (RF₁) während der Einwirkung des Magnetfeldes, der die Kernmagnetisierung in den Randbereichen, aber nicht im Isozentrum anregt,
c) Dephasierung der angeregten Kernmagnetisierung

2. MR-Verfahren nach Anspruch 1,
**gekennzeichnet durch** die Abschaltung des ortsabhängigen, kurzzeitig stationären Magnetfeldes (Bₛₐₜ) nach der Dephasierung und vor einer Anregung der Kernmagnetisierung in den von der Dephasierung nicht betroffenen Bereichen.

3. MR-Gerät zur Durchführung des Verfahrens nach Anspruch 1 mit einem Hauptfeldmagneten zur Erzeugung eines homogenen, stationären Magnetfeldes,
**gekennzeichnet durch**
- eine Sättigungspulen-Anordnung (34) zur Erzeugung eines dem homogenen, Magnetfeld überlagerbaren, ortsabhängigen und kurzzeitig stationären Magnetfeldes, dessen Feldstärke in den Randbereichen entweder größer oder kleiner als seine Feldstärke im Isozentrum ist,
- einen Hochfrequenzimpuls (RF₁) während der Einwirkung des ortsabhängigen, kurzzeitig stationären Magnetfeldes erzeugende Mittel (10... 14) wobei der Hochfrequenzimpuls die Kernmagnetisierung in den Randbereichen, aber nicht im Isozentrum anregt.
- Mittel (31,32,33) zur Dephasierung der angeregten Kernspins.

4. MR-Gerät nach Anspruch 3,
**dadurch gekennzeichnet, dass** die Sättigungspulen-Anordnung (34) drei gegeneinander räumlich versetzte, koaxiale Spulenabschnitte (341, 342, 343) aufweist, und dass im Betriebszustand der Strom in dem mittleren Spulenabschnitt (342) einen zu den Strömen in den beiden seitlichen Spulenabschnitten (341, 343) entgegengesetzten Umlaufsinn aufweist.

5. MR-Gerät nach Anspruch 4 mit mindestens einer Gradientenspulen-Anordnung (33) zur Erzeugung von magnetischen Gradientenfeldern,
**dadurch gekennzeichnet, dass** die Gradientenspulen-Anordnung zwei Abschnitte umfasst, die zwischen dem mittleren Spulenabschnitt (342) und je einem der beiden seitlichen Spulenabschnitte (341, 343) der Sättigungspulen-Anordnung (34) angeordnet sind.

## Claims

1. An MR method for suppressing MR signals from peripheral regions situated outside an isocenter,
**characterized in that** it includes the following steps:
a) generating a location-dependent, brief steady magnetic field (Bₛₐₜ) whose field strength in the peripheral regions is either larger or smaller than its field strength at the isocenter, while the peripheral regions are located on opposite sides of the isocenter,
b) generating at least one RF pulse (RF₁) during the application of the magnetic field, which RF pulse excites the nuclear magnetization in the peripheral regions but not in the isocenter,
c) dephasing the excited nuclear magnetization.

2. An MR method as claimed in claim 1,
**characterized in that** the location-dependent, brief steady magnetic field (Bₛₐₜ) is switched off after the dephasing and prior to an excitation of the nuclear magnetization in the regions not involved in the dephasing.

3. An MR apparatus for carrying out the method as claimed in claim 1, including a main field magnet for generating a uniform, steady magnetic field,
**characterized by**
- a saturation coil system (34) for generating a location-dependent, brief, steady magnetic field which can be superposed on the uniform magnetic field and whose field strength in the peripheral regions is either larger or smaller than its field strength at the isocenter,
- means (10 ... 14) for generating at least one RF pulse (RF₁) during the application of the location-dependent, brief, steady magnetic field, which RF pulse excites the nuclear magnetization in the peripheral regions but not at the isocenter, while the RF pulse excites the nuclear magnetization in the peripheral regions but not in the isocenter,
- means (31, 32, 33) for dephasing the excited nuclear spins.

4. An MR apparatus as claimed in claim 3,
**characterized in that** the saturation coil system (34) includes three coaxial coil sections (341, 342, 343) which are offset in space and that in the operating condition the direction of the current in the central coil section (342) opposes that of the currents in the two lateral coil sections (341, 343).

5. An MR apparatus as claimed in claim 4, including at least one gradient coil system (33) for generating magnetic gradient fields,
**characterized in that** the gradient coil system includes two sections which are arranged between the central coil section (342) and one of the two lateral coil sections (341, 343) of the saturation coil system (34).

## Revendications

1. Procédé RM de suppression de signaux de résonance magnétique à partir de zones périphériques à l'extérieur d'un isocentre,
**caractérisé par** les étapes suivantes :
a) production d'un champ magnétique (Bₛₐₜ) temporairement stationnaire dépendant du lieu dont l'intensité de champ dans les zones périphériques est soit supérieure, soit inférieure à son intensité de champ dans l'isocentre, les zones périphériques se trouvant sur les côtés opposés de l'isocentre;
b) production d'au moins une impulsion à haute fréquence (RF₁) pendant l'action du champ magnétique qui excite la magnétisation nucléaire dans les zones périphériques mais pas dans l'isocentre,
c) déphasage de la magnétisation nucléaire excitée.

2. Procédé RM selon la revendication 1,
**caractérisé par** la désactivation du champ magnétique (Bₛₐₜ) temporairement stationnaire dépendant du lieu après le déphasage et avant une excitation de la magnétisation nucléaire dans les zones non touchées par le déphasage.

3. Appareil RM d'exécution du procédé selon la revendication 1 avec un aimant de champ principal pour la production d'un champ magnétique stationnaire homogène,
**caractérisé par**
- un montage de bobines de saturation (34) pour la production d'un champ magnétique temporairement stationnaire dépendant du lieu, à superposer au champ magnétique homogène, dont l'intensité de champ dans les zones périphériques est soit supérieure, soit inférieure à son intensité de champ dans l'isocentre;
- une impulsion à haute fréquence (RF₁) pendant l'action des moyens (10,...,14) produisant un champ magnétique temporairement stationnaire dépendant du lieu, l'impulsion à haute fréquence excitant la magnétisation nucléaire dans les zones périphériques mais pas dans l'isocentre;
- des moyens (31, 32, 33) pour le déphasage du spin nucléaire excité.

4. Appareil RM selon revendication 3,
**caractérisé en ce que** le montage de bobines de saturation (34) présente trois sections de bobines coaxiales décalées spatialement l'une par rapport à l'autre (341, 342, 343) et que, dans l'état de fonctionnement, le courant dans la section centrale de bobines (342) présente un sens de rotation opposé aux courants dans les deux sections de bobines latérales (341, 343).

5. Appareil RM selon la revendication 4 avec au moins un montage de bobines à gradient (33) pour la production de champs à gradient magnétiques, **caractérisé en ce que** le montage de bobines à gradient comprend deux sections qui sont disposées entre la section de bobines centrale (341) et, à chaque fois, l'une des deux sections de bobines latérales (341, 343) du montage de bobines de saturation (34).
